# EUROPEAN PATENT APPLICATION

(11) **EP 4 664 770 A1**
(43) Date of publication of application: **17.12.2025**
(21) Application number: 24769677.6
(22) Date of filing: 02.02.2024
(51) Int. Cl.: H04B 1/16

(54) **RADIO FREQUENCY RECEIVING CIRCUIT, RECEIVER, AND ELECTRONIC DEVICE**

(30) Priority: 13.03.2023 CN 202310278797
(71) Applicant: Huawei Technologies Co., Ltd., Shenzhen, Guangdong 518129 (CN)
(72) Inventor: MU, Junchao, Shenzhen, Guangdong 518129 (CN); CHENG, Tao, Shenzhen, Guangdong 518129 (CN)
(74) Representative: MERH-IP Matias Erny Reichl Hoffmann Patentanwälte PartG mbB
(86) International application number: PCT/CN2024/075462
(87) International publication number: WO 2024/187981

(57) **Abstract**

This application provides a radio frequency receive circuit, a receiver, and an electronic device, to reduce interference of noise to a first voltage signal, improve a signal-to-noise ratio of the first voltage signal, and implement wide-range switching between a high gain and a low gain of a second radio frequency signal through a gain adjustment circuit, thereby expanding an application scope of the radio frequency receive circuit. The radio frequency receive circuit may include a coupling circuit, the gain adjustment circuit, and a dual balanced frequency mixer. The coupling circuit may be configured to: convert a first radio frequency signal into at least two second radio frequency signals, and output the at least two second radio frequency signals to the gain adjustment circuit. The gain adjustment circuit may be configured to: selectively amplify or attenuate a gain of each second radio frequency signal, and output at least two third radio frequency signals to the dual balanced frequency mixer. The dual balanced frequency mixer may be configured to mix the at least two third radio frequency signals based on a local oscillation signal.

## Description

This application claims priority to Chinese Patent Application No. 202310278797.0, filed with the China National Intellectual Property Administration on March 13, 2023, and entitled "RADIO FREQUENCY RECEIVE CIRCUIT, RECEIVER, AND ELECTRONIC DEVICE", which is incorporated herein by reference in its entirety.

### TECHNICAL FIELD

This application relates to the field of radio frequency technologies, and more specifically, to a radio frequency receive circuit, a receiver, and an electronic device.

### BACKGROUND

With rapid development of radio frequency technologies, a receiver is widely used in scenarios such as a seventh generation wireless network. The receiver may include a radio frequency receive circuit. To improve a signal-to-noise ratio of the radio frequency receive circuit, the radio frequency receive circuit needs to have low noise performance and high linearity performance. In addition, because an energy fluctuation range of a radio frequency signal received by the radio frequency receive circuit is large, the radio frequency receive circuit needs to implement wide-range gain switching. The radio frequency receive circuit provided in the related technology amplifies the radio frequency signal only through an amplification unit, and cannot implement wide-range switching between a high gain and a low gain of the radio frequency signal. This greatly limits an application scope of the radio frequency receive circuit.

Therefore, a technical solution that can perform wide-range gain switching on the radio frequency signal is urgently needed.

### SUMMARY

This application provides a radio frequency receive circuit, a receiver, and an electronic device, to reduce interference of noise to a first voltage signal, improve a signal-to-noise ratio of the first voltage signal, and implement switching between a high gain and a low gain of a second radio frequency signal through a gain adjustment circuit, thereby expanding an application scope of the radio frequency receive circuit.

According to a first aspect, this application provides a radio frequency receive circuit. The radio frequency receive circuit may include a coupling circuit, a gain adjustment circuit, a dual balanced frequency mixer, and a conversion circuit.

An input end of the coupling circuit may be configured to receive the first radio frequency signal, an output end of the coupling circuit may be configured to be electrically connected to an input end of the gain adjustment circuit, an output end of the gain adjustment circuit may be configured to be electrically connected to an input end of the dual balanced frequency mixer, and an output end of the dual balanced frequency mixer is used as an output end of the radio frequency receive circuit.

Optionally, the coupling circuit may be configured to: convert a first radio frequency signal into at least two second radio frequency signals, and output the at least two second radio frequency signals to the gain adjustment circuit.

The gain adjustment circuit may be configured to: selectively amplify or attenuate a gain of each of the at least two second radio frequency signals, and output the at least two third radio frequency signals to the dual balanced frequency mixer. Each of the at least two third radio frequency signals may be an amplified radio frequency signal, or may be an attenuated radio frequency signal.

The dual balanced frequency mixer may be configured to mix the at least two third radio frequency signals based on a local oscillation signal.

In this application, a gain of the second radio frequency signal may be selectively amplified or attenuated through the gain adjustment circuit, to output a high-gain third radio frequency signal or a low-gain third radio frequency signal. In other words, in this application, the gain adjustment circuit may be used to implement wide-range switching between a high gain and a low gain of the second radio frequency signal, thereby expanding the application scope of the radio frequency receive circuit.

In a possible implementation, the coupling circuit may include a first coupler. The first coupler may include a first input end, a first output end, and a second output end.

Optionally, the first input end may be configured to receive the first radio frequency signal. The first output end and the second output end may be configured to be electrically connected to the gain adjustment circuit.

For example, a phase difference between a second radio frequency signal output by the first output end and a second radio frequency signal output by the second output end may be 90 degrees.

In this application, the first coupler converts the first radio frequency signal into the two second radio frequency signals, and outputs the two second radio frequency signals with the phase difference of 90 degrees.

It can be learned that the coupling circuit may be of a single-ended structure, and can be used in a radio frequency receive circuit that has a low requirement on an anti-interference capability or a radio frequency receive circuit that has a conversion circuit with a large common-mode rejection ratio. The common-mode rejection ratio may be an absolute value of a ratio of a voltage gain of a differential-mode signal to a voltage gain of a common-mode signal.

Further, the first coupler may include a third capacitor, a fourth capacitor, a fifth capacitor, a first matching resistor, and a first transformer. The first transformer may include a first primary-side winding and a first secondary-side winding that are coupled to each other.

Optionally, one end of the third capacitor is electrically connected to a first end of the first primary-side winding, and is used as the first input end of the first coupler. A first end of the fourth capacitor is electrically connected to a second end of the first primary-side winding, and is used as the first output end of the first coupler. A second end of the third capacitor is electrically connected to a first end of the first secondary-side winding, and is used as the second output end of the first coupler. A second end of the fourth capacitor, a second end of the first secondary-side winding, and a first end of the first matching resistor are electrically connected. A second end of the first matching resistor is electrically connected to a first end of the fifth capacitor. A second end of the fifth capacitor is electrically connected to a ground end.

Based on the foregoing coupling circuit, the gain adjustment circuit may include a first gain adjustment unit and a second gain adjustment unit. In other words, the gain adjustment circuit may include a plurality of gain adjustment units.

Each gain adjustment unit may include a second input end, a third output end, and a fourth output end. In other words, the first gain adjustment unit and the second gain adjustment unit each include one input end and two output ends.

A second input end of the first gain adjustment unit may be configured to be electrically connected to the first output end, a second input end of the second gain adjustment unit may be configured to be electrically connected to the second output end, and a third output end of the first gain adjustment unit, a fourth output end of the first gain adjustment unit, a third output end of the second gain adjustment unit, and a fourth output end of the second gain adjustment unit may be all configured to be electrically connected to the dual balanced frequency mixer.

A phase difference between a third radio frequency signal output by the third output end and a third radio frequency signal output by the fourth output end is 180 degrees. Because a gain of the third radio frequency signal output by the third output end is the same as a gain of the third radio frequency signal output by the fourth output end, the third radio frequency signal output by the third output end and the third radio frequency signal output by the fourth output end may be differential signals.

It may be understood that the third radio frequency signal output by the third output end of the first gain adjustment unit may be a radio frequency signal obtained through gain amplification, and the third radio frequency signal output by the fourth output end of the first gain adjustment unit may be a radio frequency signal obtained through gain attenuation. Similarly, the third radio frequency signal output by the third output end of the second gain adjustment unit may also be a radio frequency signal obtained through gain amplification, and the third radio frequency signal output by the fourth output end of the second gain adjustment unit may also be a radio frequency signal obtained through gain attenuation. Because the gain adjustment circuit may selectively amplify or attenuate the gain of each second radio frequency signal, the third radio frequency signal may have the following four cases.

Case 1: The third radio frequency signal output by each of the first gain adjustment unit and the second gain adjustment unit is the radio frequency signal obtained through gain amplification. In this case, the third radio frequency signal output by the gain adjustment circuit may include the two radio frequency signals obtained through gain amplifications.

Case 2: The third radio frequency signal output by each of the first gain adjustment unit and the second gain adjustment unit is the radio frequency signal obtained through gain attenuation. In this case, the third radio frequency signal output by the gain adjustment circuit may include the two radio frequency signals obtained through gain attenuation.

Case 3: The third radio frequency signal output by the first gain adjustment unit is the radio frequency signal obtained through gain amplification, and the third radio frequency signal output by the second gain adjustment unit is the radio frequency signal obtained through gain attenuation. In this case, the third radio frequency signal output by the gain adjustment circuit may include the radio frequency signal obtained through gain amplification and the radio frequency signal obtained through gain attenuation.

Case 4: The third radio frequency signal output by the first gain adjustment unit is the radio frequency signal obtained through gain attenuation, and the third radio frequency signal output by the second gain adjustment unit is the radio frequency signal obtained through gain amplification. In this case, same as Case 3, the third radio frequency signal output by the gain adjustment circuit may also include the radio frequency signal obtained through gain amplification and the radio frequency signal obtained through gain attenuation.

In this application, the first gain adjustment unit and the second gain adjustment unit can adjust gains of the two second radio frequency signals, and can output the two third radio frequency signals.

In another possible implementation, in addition to the first coupler, the coupling circuit may further include a second coupler and a conversion unit.

The first coupler includes a first input end, a first output end, and a second output end. The second coupler may include a third input end, a fifth output end, and a sixth output end. The conversion unit may include a fourth input end, a seventh output end, and an eighth output end.

Optionally, the fourth input end may be configured to receive the first radio frequency signal, the seventh output end may be configured to be electrically connected to the first input end, the eighth output end may be configured to be electrically connected to the third input end, and the first output end, the second output end, the fifth output end, and the sixth output end may be configured to be electrically connected to the gain adjustment circuit.

For example, a phase difference between a second radio frequency signal output by the first output end and a second radio frequency signal output by the second output end may be 90 degrees. A phase difference between a second radio frequency signal output by the fifth output end and a second radio frequency signal output by the sixth output end may be 90 degrees. A phase difference between a second radio frequency signal output by the first output end and a second radio frequency signal output by the fifth output end may be 180 degrees. A phase difference between a second radio frequency signal output by the second output end and a second radio frequency signal output by the sixth output end may be 180 degrees. Because a gain of the second radio frequency signal output by the first output end is the same as a gain of the second radio frequency signal output by the fifth output end, the second radio frequency signal output by the first output end and the second radio frequency signal output by the fifth output end may be differential signals. Similarly, because a gain of the second radio frequency signal output by the second output end is the same as a gain of the second radio frequency signal output by the sixth output end, the second radio frequency signal output by the second output end and the second radio frequency signal output by the sixth output end may also be differential signals.

In this application, the first coupler, the second coupler, and the conversion unit convert the first radio frequency signal into four second radio frequency signals, and output the four second radio frequency signals. In the four second radio frequency signals, the second radio frequency signal output by the first output end and the second radio frequency signal output by the fifth output end may be the differential signals, and the second radio frequency signal output by the second output end and the second radio frequency signal output by the sixth output end may also be the differential signals. Therefore, it may be considered that the coupling circuit uses a fully differential structure, so that an input second-order intercept point (input second-order intercept point, IIP2) can be increased, thereby improving an anti-interference capability of the radio frequency receive circuit.

Further, similar to the first coupler, the second coupler may include a sixth capacitor, a seventh capacitor, an eighth capacitor, a second matching resistor, and a second transformer. The second transformer may include a second primary-side winding and a second secondary-side winding that are coupled to each other.

Optionally, one end of the sixth capacitor is electrically connected to a first end of the second primary-side winding, and is used as the third input end of the second coupler. A first end of the seventh capacitor is electrically connected to a second end of the second primary-side winding, and is used as the fifth output end of the second coupler. A second end of the sixth capacitor is electrically connected to a first end of the second secondary-side winding, and is used as the sixth output end of the second coupler. A second end of the seventh capacitor, a second end of the second secondary-side winding, and a first end of the second matching resistor are electrically connected. A second end of the second matching resistor is electrically connected to a first end of the eighth capacitor. A second end of the eighth capacitor is electrically connected to a ground end.

The conversion unit may include a ninth capacitor and a third transformer. The third transformer may include a third primary-side winding and a third secondary-side winding that are coupled to each other.

Optionally, a first end of the ninth capacitor is electrically connected to a first end of the third primary-side winding, and is used as a fourth input end of the conversion unit, that is, the input end of the coupling circuit. A second end of the ninth capacitor and a second end of the third primary-side winding are electrically connected to a ground end. A first end of the third secondary-side winding may be used as the seventh output end of the conversion unit, and a second end of the third secondary-side winding is used as the eighth output end of the conversion unit.

Based on the foregoing coupling circuit, the plurality of gain adjustment units may include a first gain adjustment unit, a second gain adjustment unit, a third gain adjustment unit, and a fourth gain adjustment unit. In other words, the gain adjustment circuit may include a plurality of gain adjustment units.

Each gain adjustment unit includes a second input end, a third output end, and a fourth output end. In other words, each of the first gain adjustment unit, the second gain adjustment unit, the third gain adjustment unit, and the fourth gain adjustment unit may include one input end and two output ends.

A second input end of the first gain adjustment unit may be configured to be electrically connected to the first output end. A second input end of the second gain adjustment unit may be configured to be electrically connected to the second output end. A second input end of the third gain adjustment unit may be configured to be electrically connected to the fifth output end. A second input end of the fourth gain adjustment unit may be configured to be electrically connected to the sixth output end. A third output end of the first gain adjustment unit, a fourth output end of the first gain adjustment unit, a third output end of the second gain adjustment unit, a fourth output end of the second gain adjustment unit, a third output end of the third gain adjustment unit, a fourth output end of the third gain adjustment unit, a third output end of the fourth gain adjustment unit, and a fourth output end of the fourth gain adjustment unit may all be configured to be electrically connected to the dual balanced frequency mixer.

For example, a phase difference between a third radio frequency signal output by the third output end and a third radio frequency signal output by the fourth output end may be 180 degrees. Because a gain of the third radio frequency signal output by the third output end is the same as a gain of the third radio frequency signal output by the fourth output end, the third radio frequency signal output by the third output end and the third radio frequency signal output by the fourth output end may be differential signals.

It may be understood that a third radio frequency signal output by the third output end of each of the first gain adjustment unit, the second gain adjustment unit, the third gain adjustment unit, and the fourth gain adjustment unit may be a radio frequency signal obtained through gain amplification. A third radio frequency signal output by the fourth output end of each of the first gain adjustment unit, the second gain adjustment unit, the third gain adjustment unit, and the fourth gain adjustment unit may be a radio frequency signal obtained through gain attenuation. Because the gain adjustment circuit may selectively amplify or attenuate the gain of each second radio frequency signal, the third radio frequency signal may have the following several cases.

Case 1: The third radio frequency signal output by each of the first gain adjustment unit, the second gain adjustment unit, the third gain adjustment unit, and the fourth gain adjustment unit may be the radio frequency signal obtained through gain amplification. In this case, the third radio frequency signal output by the gain adjustment circuit may include four radio frequency signals obtained through gain amplification.

Case 2: The third radio frequency signal output by each of the first gain adjustment unit, the second gain adjustment unit, the third gain adjustment unit, and the fourth gain adjustment unit may be the radio frequency signal obtained through gain attenuation. In this case, the third radio frequency signal output by the gain adjustment circuit may include four radio frequency signals obtained through gain attenuation.

Case 3: Third radio frequency signals output by some of the first gain adjustment unit, the second gain adjustment unit, the third gain adjustment unit, and the fourth gain adjustment unit may be radio frequency signals obtained through gain amplification, and third radio frequency signals output by the other gain adjustment units may be radio frequency signals obtained through gain attenuation. In this case, the third radio frequency signal output by the gain adjustment circuit may include at least one radio frequency signal obtained through gain amplification and a plurality of radio frequency signal obtained through gain attenuation, or may include a plurality of radio frequency signals obtained through gain amplification and at least one radio frequency signal obtained through gain attenuation.

In this application, the first gain adjustment unit, the second gain adjustment unit, the third gain adjustment unit, and the fourth can adjust gains of the four second radio frequency signals, and can output the four third radio frequency signals.

In still another possible implementation, each gain adjustment unit may include a first amplification unit and an attenuation unit. The first amplification unit may include a first switch and a radio frequency low noise amplifier (radio frequency low noise amplifier, RFLNA) that are connected in series.

A first end of the attenuation unit and the first switch may be used as the second input end of each gain adjustment unit, the radio frequency low noise amplifier may be used as the third output end of each gain adjustment unit, and a second end of the attenuation unit may be used as the fourth output end of each gain adjustment unit.

Optionally, the first amplification unit may be configured to: when the first switch is turned on, perform multi-level amplification on a gain of the second radio frequency signal through the radio frequency low noise amplifier, and output an amplified radio frequency signal.

The attenuation unit may be configured to: when the first switch is turned off, perform multi-level attenuation on the gain of the second radio frequency signal, and output an attenuated radio frequency signal.

It can be learned that, in this application, the first amplification unit may implement multi-level amplification of the gain of the second radio frequency signal, and output the high-gain third radio frequency signal. In this application, the attenuation unit may implement multi-level attenuation of the gain of the second radio frequency signal, and output the low-gain third radio frequency signal. In other words, wide-range switching between a high gain and a low gain of the second radio frequency signal can be implemented through the gain adjustment circuit, thereby expanding an application scope of the radio frequency receive circuit.

In an example, the radio frequency low noise amplifier may include a fifth switching transistor, a sixth switching transistor, a fourth resistor, and a tenth capacitor. A control electrode of the fifth switching transistor may be electrically connected to a first end of the fourth resistor. A first electrode of the fifth switching transistor may be configured to receive an operating voltage. A second electrode of the fifth switching transistor, a first electrode of the sixth switching transistor, and a second end of the fourth resistor are electrically connected, to be used as an output end of the radio frequency low noise amplifier. A first end of the tenth capacitor may be electrically connected to the control electrode of the fifth switching transistor, and a second end of the tenth capacitor may be electrically connected to a control electrode of the sixth switching transistor, to be used as an input end of the radio frequency low noise amplifier. A second electrode of the sixth switching transistor is electrically connected to a ground end.

For example, the fifth switching transistor may be a P-type metal-oxide-semiconductor field-effect transistor (metal-oxide-semiconductor field-effect transistor, MOSFET), that is, a PMOS transistor. The sixth switching transistor may be an N-type metal-oxide-semiconductor field-effect transistor, that is, an NMOS transistor. Certainly, the fifth switching transistor and the sixth switching transistor each may alternatively be another semiconductor device. This is not limited in this application.

In another example, the attenuation unit may include a plurality of attenuation branches connected in parallel. Each of the plurality of attenuation branches may include a first resistor and a switch that are connected in series.

First ends of the first resistors in the attenuation branches are electrically connected to be used as the first end of the attenuation unit. A second end of the first resistor in each attenuation branch is electrically connected to a first end of the corresponding switch, and second ends of switches in the attenuation branches are electrically connected to be used as the second end of the attenuation unit.

It can be figured out that, in this application, multi-level attenuation of the gain of the second radio frequency signal may be implemented based on that at least one of the plurality of switches is turned on. In other words, in this application, wide-range attenuation of the gain of the second radio frequency signal may be implemented, so that the second end of the attenuation unit outputs a multi-level low-gain third radio frequency signal.

In another possible implementation, the dual balanced frequency mixer may include a plurality of frequency mixing units. Each of the plurality of frequency mixing units may include a first switching transistor, a second switching transistor, a third switching transistor, and a fourth switching transistor.

Optionally, control electrodes of the first switching transistor, the second switching transistor, the third switching transistor, and the fourth switching transistor may all be configured to receive a local oscillation signal. First electrodes of the first switching transistor, the second switching transistor, the third switching transistor, and the fourth switching transistor may be configured to be electrically connected to the gain adjustment circuit. Second electrodes of the first switching transistor, the second switching transistor, the third switching transistor, and the fourth switching transistor may be electrically connected, and are used as an output end of the frequency mixing unit.

It can be learned that the frequency mixing unit may adjust a frequency of each third radio frequency signal through the four switching transistors, and output a current signal. In other words, the frequency mixing unit may control on and off of the four switching transistors based on a frequency of the local oscillation signal, to implement conversion from the third radio frequency signal to the current signal.

Further, the first switching transistor, the second switching transistor, the third switching transistor, and the fourth switching transistor each may be an NMOS transistor. Certainly, the first switching transistor, the second switching transistor, the third switching transistor, and the fourth switching transistor each may alternatively be another semiconductor device. This is not limited in this application.

For example, the local oscillation signal may include a local oscillation in-phase positive signal LOIP with a duty cycle of 25%, a local oscillation in-phase negative signal LOIN with a duty cycle of 25%, a local oscillation quadrature positive signal LOQP with a duty cycle of 25%, and a local oscillation quadrature negative signal LOQN with a duty cycle of 25%. Certainly, the local oscillation signal may alternatively use another duty cycle other than 25%. This is not limited in this application.

Optionally, a phase difference between the local oscillation quadrature positive signal LOQP and the local oscillation in-phase positive signal LOIP may be 90 degrees, a phase difference between the local oscillation in-phase negative signal LOIN and the local oscillation in-phase positive signal LOIP may be 180 degrees, and a phase difference between the local oscillation quadrature negative signal LOQN and the local oscillation in-phase positive signal LOIP may be 270 degrees.

For example, the plurality of frequency mixing units include a first frequency mixing unit, a second frequency mixing unit, a third frequency mixing unit, and a fourth frequency mixing unit.

A control electrode of a first switching transistor in the first frequency mixing unit, a control electrode of a second switching transistor in the second frequency mixing unit, a control electrode of a third switching transistor in the third frequency mixing unit, and a control electrode of a fourth switching transistor in the fourth frequency mixing unit may be configured to receive the local oscillation in-phase positive signal LOIP. A control electrode of a second switching transistor in the first frequency mixing unit, a control electrode of a first switching transistor in the second frequency mixing unit, a control electrode of a fourth switching transistor in the third frequency mixing unit, and a control electrode of a third switching transistor in the fourth frequency mixing unit may be configured to receive the local oscillation in-phase negative signal LOIN. A control electrode of a fourth switching transistor in the first frequency mixing unit, a control electrode of a third switching transistor in the second frequency mixing unit, a control electrode of a first switching transistor in the third frequency mixing unit, and a control electrode of a second switching transistor in the fourth frequency mixing unit may be configured to receive the local oscillation quadrature positive signal LOQP. A control electrode of a third switching transistor in the first frequency mixing unit, a control electrode of a fourth switching transistor in the second frequency mixing unit, a control electrode of a second switching transistor in the third frequency mixing unit, and a control electrode of a first switching transistor in the fourth frequency mixing unit may be configured to receive the local oscillation quadrature negative signal LOQN.

A first electrode of the first switching transistor in each frequency mixing unit may be configured to be electrically connected to the fourth output end of the first gain adjustment unit. A first electrode of the second switching transistor in each frequency mixing unit may be configured to be electrically connected to the third output end of the first gain adjustment unit. A first electrode of the third switching transistor in each frequency mixing unit may be configured to be electrically connected to the fourth output end of the second gain adjustment unit. A first electrode of the fourth switching transistor in each frequency mixing unit may be configured to be electrically connected to the third output end of the second gain adjustment unit.

In this application, each switching transistor of the dual balanced frequency mixer may be turned on or off based on the local oscillation signal received by the control electrode, and output two current signals based on the third radio frequency signals output by the first gain adjustment unit and the second gain adjustment unit.

Further, the first electrode of the first switching transistor in each frequency mixing unit may be further configured to be electrically connected to the third output end of the third gain adjustment unit, the first electrode of the second switching transistor in each frequency mixing unit may be further configured to be electrically connected to the fourth output end of the third gain adjustment unit, the first electrode of the third switching transistor in each frequency mixing unit may be further configured to be electrically connected to the third output end of the fourth gain adjustment unit, and the first electrode of the fourth switching transistor in each frequency mixing unit may be further configured to be electrically connected to the fourth output end of the fourth gain adjustment unit.

It can be learned that, in this application, the dual balanced frequency mixer may output four current signals based on the third radio frequency signals output by the first gain adjustment unit, the second gain adjustment unit, the third gain adjustment unit, and the fourth gain adjustment unit.

In a possible implementation, the radio frequency receive circuit provided in this application may further include a conversion circuit. An input end of the conversion circuit may be electrically connected to the output end of the dual balanced frequency mixer, and an output end of the conversion circuit may be used as the output end of the radio frequency receive circuit.

The conversion circuit may be configured to: convert a current signal output by the dual balanced frequency mixer into a first voltage signal, and output the first voltage signal. It may be understood that an input signal of the radio frequency receive circuit may be the first radio frequency signal, and an output signal may be the first voltage signal.

In the radio frequency receive circuit provided in this application, because the coupling circuit may have a noise cancellation function, the radio frequency receive circuit can reduce interference of noise to the first voltage signal, and improve a signal-to-noise ratio of the first voltage signal. In other words, the radio frequency receive circuit provided in this application may have low noise performance.

Further, the conversion circuit may include a first transimpedance amplification unit and a second transimpedance amplification unit.

The first transimpedance amplification unit and the second transimpedance amplification unit may each include a second amplification unit, a first capacitor, a second resistor, a second capacitor, and a third resistor. The second amplification unit includes a fifth input end, a sixth input end, a ninth output end, and a tenth output end.

Optionally, a first end of each of the first capacitor and the second resistor may be configured to be electrically connected to the fifth input end, and a second end of each of the first capacitor and the second resistor may be configured to be electrically connected to the ninth output end. In other words, the first capacitor and the second resistor may be bridged between the fifth input end and the ninth output end of the second amplification unit.

Similarly, a first end of each of the second capacitor and the third resistor may be configured to be electrically connected to the sixth input end, and a second end of each of the second capacitor and the third resistor may be configured to be electrically connected to the tenth output end. In other words, the second capacitor and the third resistor may be bridged between the sixth input end and the tenth output end of the second amplification unit.

For the first transimpedance amplification unit, the fifth input end of the second amplification unit may be configured to be electrically connected to an output end of the first frequency mixing unit, and the sixth input end of the second amplification unit may be configured to be electrically connected to an output end of the second frequency mixing unit.

Similarly, for the second transimpedance amplification unit, the fifth input end of the second amplification unit may be configured to be electrically connected to an output end of the third frequency mixing unit, and the sixth input end of the second amplification unit may be configured to be electrically connected to an output end of the fourth frequency mixing unit.

The ninth output end of the second amplification unit in the first transimpedance amplification unit, the tenth output end of the second amplification unit in the first transimpedance amplification unit, the ninth output end of the second amplification unit in the second transimpedance amplification unit, and the tenth output end of the second amplification unit in the second transimpedance amplification unit may be configured to output the first voltage signal.

It can be learned that, in this application, the first transimpedance amplification unit and the second transimpedance amplification unit can convert the current signal into the first voltage signal, and can output the four first voltage signals.

Further, in the first amplification unit and the second amplification unit, the fifth input end and the tenth output end may have a same phase, and the sixth input end and the ninth output end may have a same phase.

For example, both the first amplification unit and the second amplification unit may be operational amplifiers (operational amplifier, OPA). Certainly, the first amplification unit and the second amplification unit may alternatively be amplifiers of other types. This is not limited in this application.

The radio frequency receive circuit provided in this application not only has low noise, but also can implement flexible switching between a high gain and a multi-level low gain of the second radio frequency signal. In addition, the radio frequency receive circuit has high linearity performance, thereby improving error vector magnitude (error vector magnitude, EVM) performance of the radio frequency receive circuit.

According to a second aspect, this application provides a receiver, including an antenna, a baseband processing circuit, and the radio frequency receive circuit provided in the first aspect and the possible implementations of the first aspect. The antenna and the baseband processing circuit each may be electrically connected to the radio frequency receive circuit.

The antenna may be configured to send a first radio frequency signal to the radio frequency receive circuit.

The baseband processing circuit may be configured to: filter and convert a first voltage signal sent by the radio frequency receive circuit, and output a second voltage signal. The second voltage signal may be used to indicate a voltage signal obtained through filtering and conversion.

According to a third aspect, this application provides an electronic device, including the receiver provided in the second aspect.

Optionally, the electronic device may be a mobile phone, a router, or the like. Certainly, the electronic device may alternatively be another device. This is not limited in this application.

It should be understood that the technical solutions in the second aspect to the fifth aspect of this application are consistent with the technical solutions in the first aspect of this application, beneficial effects achieved by the aspects and corresponding feasible implementations are similar, and details are not described again.

### BRIEF DESCRIPTION OF DRAWINGS

To describe the technical solutions in this application or in the conventional technology more clearly, the following briefly describes the accompanying drawings used for describing embodiments or the conventional technology. Apparently, the accompanying drawings in the following descriptions show some embodiments of this application, and a person of ordinary skill in the art may still derive other accompanying drawings from these accompanying drawings without creative efforts.
FIG. 1 is a diagram of a structure of a radio frequency receive circuit 10 according to an embodiment of this application;
FIG. 2 is another diagram of a structure of a radio frequency receive circuit 10 according to an embodiment of this application;
FIG. 3 is still another diagram of a structure of a radio frequency receive circuit 10 according to an embodiment of this application;
FIG. 4 is yet another diagram of a structure of a radio frequency receive circuit 10 according to an embodiment of this application;
FIG. 5 is a diagram of a structure of an amplification unit 21 according to an embodiment of this application; and
FIG. 6 is a diagram of a structure of a receiver 100 according to an embodiment of this application.

### DESCRIPTION OF EMBODIMENTS

The following describes technical solutions of this application with reference to accompanying drawings.

In the specification, embodiments, claims, and accompanying drawings of this application, terms such as "first" and "second" are merely used for differentiation and description, but should not be understood as an indication or implication of relative importance or an indication or implication of a sequence. In addition, the terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

With rapid development of radio frequency technologies, a receiver is widely used in scenarios such as a seventh generation wireless network. The receiver may include a radio frequency receive circuit. To improve a signal-to-noise ratio of the radio frequency receive circuit, the radio frequency receive circuit needs to have low noise performance and high linearity performance. In addition, because an energy fluctuation range of a radio frequency signal received by the radio frequency receive circuit is large, the radio frequency receive circuit needs to implement wide-range gain switching. The radio frequency receive circuit provided in the related technology amplifies the radio frequency signal only through an amplification unit, and cannot implement wide-range switching between a high gain and a low gain of the radio frequency signal. This greatly limits an application scope of the radio frequency receive circuit.

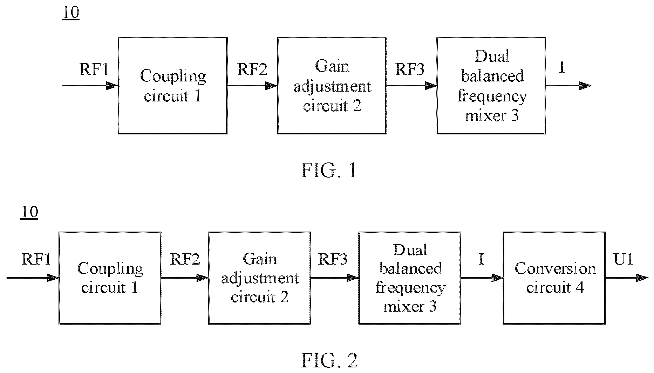

To overcome the foregoing disadvantages, an embodiment of this application provides a radio frequency receive circuit, as shown in FIG. 1. A radio frequency receive circuit 10 may include a coupling circuit 1, a gain adjustment circuit 2, and a dual balanced frequency mixer 3.

An input end of the coupling circuit 1 may be configured to receive a radio frequency signal RF1 (that is, a first radio frequency signal), an output end of the coupling circuit 1 may be configured to be electrically connected to an input end of the gain adjustment circuit 2, an output end of the gain adjustment circuit 2 may be configured to be electrically connected to an input end of the dual balanced frequency mixer 3, and an output end of the dual balanced frequency mixer 3 may be used as an output end of the radio frequency receive circuit 10.

Optionally, the coupling circuit 1 may be configured to: convert the radio frequency signal RF1 into at least two radio frequency signals RF2 (that is, second radio frequency signals), and output the at least two radio frequency signals RF2 to the gain adjustment circuit 2.

The gain adjustment circuit 2 may be configured to: selectively amplify or attenuate a gain of each of the at least two radio frequency signals RF2, and output at least two radio frequency signals RF3 (that is, third radio frequency signals) to the dual balanced frequency mixer 3. Each of the at least two radio frequency signals RF3 may be used to indicate an amplified radio frequency signal or an attenuated radio frequency signal.

The dual balanced frequency mixer 3 may be configured to mix the at least two radio frequency signals RF3 based on a local oscillation signal.

For example, a signal output by the dual balanced frequency mixer 3 may be a current signal I obtained through frequency mixing. A frequency of the current signal I is a frequency obtained through frequency mixing.

In this embodiment of this application, a gain of the radio frequency signal RF2 may be selectively amplified or attenuated through the gain adjustment circuit 2, to output a high-gain radio frequency signal RF3 or a low-gain radio frequency signal RF3. In other words, in this embodiment of this application, the gain adjustment circuit 2 may be used to implement wide-range switching between a high gain and a low gain of the radio frequency signal RF2. This expands an application scope of the radio frequency receive circuit 10.

For example, the local oscillation signal may include a local oscillation in-phase positive signal LOIP with a duty cycle of 25%, a local oscillation in-phase negative signal LOIN with a duty cycle of 25%, a local oscillation quadrature positive signal LOQP with a duty cycle of 25%, and a local oscillation quadrature negative signal LOQN with a duty cycle of 25%. Certainly, the local oscillation signal may alternatively use another duty cycle other than 25%. This is not limited in this embodiment of this application.

Optionally, a phase difference between the local oscillation quadrature positive signal LOQP and the local oscillation in-phase positive signal LOIP may be 90 degrees, a phase difference between the local oscillation in-phase negative signal LOIN and the local oscillation in-phase positive signal LOIP may be 180 degrees, and a phase difference between the local oscillation quadrature negative signal LOQN and the local oscillation in-phase positive signal LOIP may be 270 degrees.

Further, the radio frequency receive circuit 10 provided in this embodiment of this application may further include a conversion circuit 4, as shown in FIG. 2. An input end of the conversion circuit 4 may be electrically connected to the output end of the dual balanced frequency mixer 3, and an output end of the conversion circuit 4 may be used as the output end of the radio frequency receive circuit 10.

The conversion circuit 4 may be configured to: convert the current signal I output by the dual balanced frequency mixer 3 into a voltage signal U1 (that is, a first voltage signal), and output the voltage signal U1. It may be understood that an input signal of the radio frequency receive circuit may be the radio frequency signal RF1, and an output signal may be the voltage signal U1.

In the radio frequency receive circuit 10 provided in this embodiment of this application, because the coupling circuit 1 may have a noise cancellation function, the radio frequency receive circuit 10 can reduce interference of noise to the voltage signal U1, and improve a signal-to-noise ratio of the voltage signal U1. In other words, the radio frequency receive circuit 10 provided in this embodiment of this application may have low noise performance.

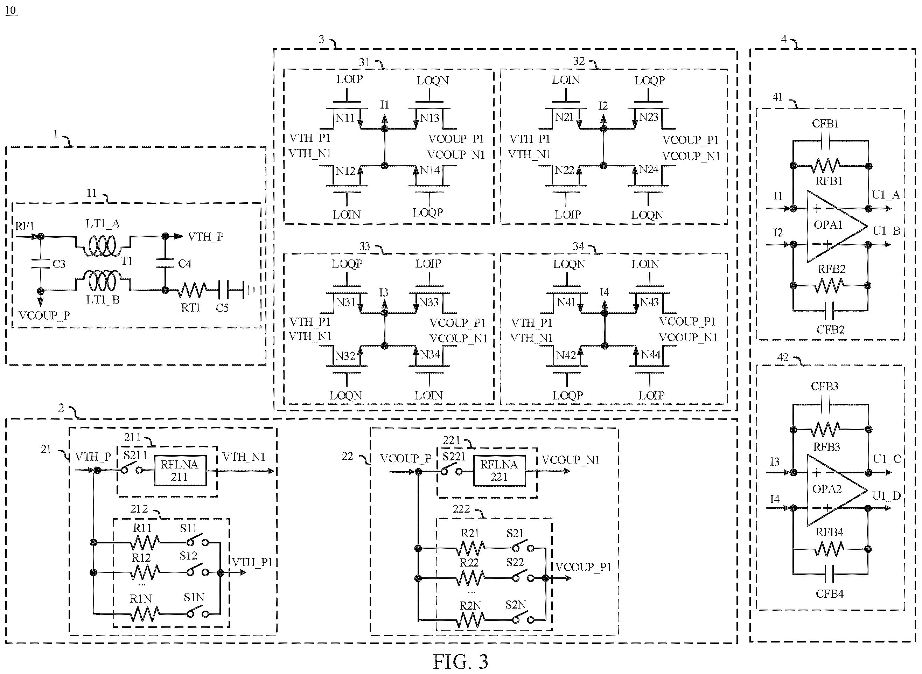

In some embodiments, as shown in FIG. 3, the coupling circuit 1 may include a coupler 11 (that is, a first coupler).

The coupler 11 may include a capacitor C3 (that is, a third capacitor), a capacitor C4 (that is, a fourth capacitor), a capacitor C5 (that is, a fifth capacitor), a matching resistor RT1 (that is, a first matching resistor), and a transformer T1 (that is, a first transformer). The transformer T1 may include a primary-side winding LT1_A (that is, a first primary-side winding) and a secondary-side winding LT1_B (that is, a first secondary-side winding) that are coupled to each other.

Optionally, one end of the capacitor C3 is electrically connected to a first end of the primary-side winding LT1_A, and is used as a first input end of the coupler 11. The first input end may be configured to receive the radio frequency signal RF1. A first end of the capacitor C4 is electrically connected to a second end of the primary-side winding LT1_A, is used as a first output end of the coupler 11, and is configured to output a radio frequency signal VTH_P (that is, one of the radio frequency signals RF2). A second end of the capacitor C3 is electrically connected to a first end of the secondary-side winding LT1_B, is used as a second output end of the coupler 11, and is configured to output a radio frequency signal VCOUP_P (that is, another radio frequency signal RF2). A second end of the capacitor C4, a second end of the secondary-side winding LT1_B, and a first end of the matching resistor RT1 are electrically connected. A second end of the matching resistor RT1 is electrically connected to a first end of the capacitor C5. A second end of the capacitor C5 is electrically connected to a ground end. It can be learned that the radio frequency signals RF2 may include the radio frequency signal VTH_P and the radio frequency signal VCOUP_P.

Because the coupling circuit 1 is electrically connected to the gain adjustment circuit 2, it may be figured out that the coupler 11 may output the radio frequency signal VCOUP_P and the radio frequency signal VTH_P to the gain adjustment circuit 2 through the first output end and the second output end. A phase difference between the radio frequency signal VCOUP_P and the radio frequency signal VTH_P may be 90 degrees.

In this embodiment of this application, conversion from the radio frequency signal RF1 to two radio frequency signals RF2 may be implemented through the coupler 11, and the radio frequency signal VCOUP_P and the radio frequency signal VTH_P whose phase difference is 90 degrees are output.

It can be learned that the coupling circuit 1 in FIG. 3 may be of a single-ended structure, and can be used in a radio frequency receive circuit 10 that does not have a high requirement on an anti-interference capability or a radio frequency receive circuit 10 that has a conversion circuit 4 with a large common-mode rejection ratio. The common-mode rejection ratio may be an absolute value of a ratio of a voltage gain of a differential-mode signal to a voltage gain of a common-mode signal.

Still refer to FIG. 3. The gain adjustment circuit 2 may include a gain adjustment unit 21 (that is, a first gain adjustment unit) and a gain adjustment unit 22 (that is, a second gain adjustment unit). In other words, the gain adjustment circuit 2 may include a plurality of gain adjustment units.

The gain adjustment unit 21 may include an amplification unit 211 (that is, a first amplification unit) and an attenuation unit 212. The amplification unit 211 may include a switch S211 (that is, a first switch) and a radio frequency low noise amplifier (radio frequency low noise amplifier, RFLNA) 211 that are connected in series.

A first end of the attenuation unit 212 and the switch S211 are used as second input ends of the gain adjustment unit 21, the RFLNA 211 is used as a third output end of the gain adjustment unit 21, and a second end of the attenuation unit 212 is used as a fourth output end of the gain adjustment unit 21.

The amplification unit 211 may be configured to: when the switch S211 is turned on, perform multi-level amplification on a gain of the radio frequency signal VTH_P through the RFLNA 211, and output a radio frequency signal VTH_N1 (that is, the amplified radio frequency signal VTH_P, that is, the radio frequency signal RF3).

The attenuation unit 212 may be configured to: when the switch S211 is turned off, perform multi-level attenuation on the gain of the radio frequency signal VTH_P, and output a radio frequency signal VTH_P1 (that is, the attenuated radio frequency signal VTH_P, that is, the radio frequency signal RF3).

Certainly, to amplify the gain of the radio frequency signal VTH_P, the amplification unit 211 may further include an amplifier of another type other than the RFLNA 211. This is not limited in this embodiment of this application.

In another example, the attenuation unit 212 may include N parallel attenuation branches. As shown in FIG. 3, in the attenuation unit 212, each attenuation branch may include a first resistor and a second switch that are connected in series.

For example, a first attenuation branch may include a resistor R11 (that is, a first resistor) and a switch S11 (that is, a second switch) that are connected in series.

For another example, a second attenuation branch may include a resistor R12 (that is, a first resistor) and a switch S12 (that is, a second switch) that are connected in series.

For another example, an N^{th} attenuation branch may include a resistor R1N (that is, a first resistor) and a switch S1N (that is, a second switch) that are connected in series.

For example, first ends of the first resistors in the attenuation branches are electrically connected to be used as the first end of the attenuation unit 212. A second end of the first resistor in each attenuation branch is electrically connected to a first end of the corresponding switch, and second ends of switches in the attenuation branches are electrically connected to be used as the second end of the attenuation unit 212.

A first end of the attenuation unit 212 is electrically connected to the first end of the radio frequency receive circuit 211, may be used as an input end (that is, a second input end) of the gain adjustment unit 21, and is configured to receive the radio frequency signal VTH_P output by the first output end of the coupler 11. A second end of the amplification unit 211 may be used as one of output ends (that is, a third output end) of the gain adjustment unit 21, and is configured to output the radio frequency signal VTH_N1 to the dual balanced frequency mixer 3. A second end of the attenuation unit 212 may be used as another output end (that is, a fourth output end) of the gain adjustment unit 21, and is configured to output the radio frequency signal VTH_P1 to the dual balanced frequency mixer 3.

It may be figured out that the gain adjustment unit 21 may selectively output the radio frequency signal VTH_N1 or the radio frequency signal VTH_P1 based on an application scenario of the radio frequency receive circuit 10. A phase difference between the radio frequency signal VTH_N1 and the radio frequency signal VTH_P may be 180 degrees. Because the radio frequency signal VTH_N1 and the radio frequency signal VTH_P have a same gain, the radio frequency signal VTH_N1 and the radio frequency signal VTH_P may be differential signals.

It can be figured out that, in this embodiment of this application, multi-level attenuation of the gain of the radio frequency signal VTH_P may be implemented based on that at least one of the plurality of switches in the attenuation unit 212 is turned on. In other words, in this embodiment of this application, wide-range attenuation of the gain of the radio frequency signal VTH_P can be implemented, so that the second end of the attenuation unit 212 outputs the multi-level low-gain radio frequency signal VTH_P1.

Similar to the gain adjustment unit 21, the gain adjustment unit 22 may include an amplification unit 221 (that is, a first amplification unit) and an attenuation unit 222, as shown in FIG. 3. The amplification unit 221 may also include a switch S221 (that is, a first switch) and an RFLNA 221 that are connected in series.

The switch S221 and a first end of the attenuation unit 222 are used as second input ends of the gain adjustment unit 22, the RFLNA 221 is used as a third output end of the gain adjustment unit 22, and a second end of the attenuation unit 222 is used as a fourth output end of the gain adjustment unit 22.

The amplification unit 221 may be configured to: when the switch S221 is turned on, perform multi-level amplification on a gain of the radio frequency signal VCOUP_P through the RFLNA 221, and output a radio frequency signal VCOUP_N1 (that is, the amplified radio frequency signal VCOUP_P, that is, the radio frequency signal RF3).

The attenuation unit 222 may be configured to: when the switch S221 is turned off, perform multi-level attenuation on the gain of the radio frequency signal VCOUP_P, and output a radio frequency signal VCOUP_P1 (that is, the attenuated radio frequency signal VCOUP_P, that is, the radio frequency signal RF3).

Certainly, to amplify the gain of the radio frequency signal VCOUP_P, the amplification unit 221 may further include an amplifier of another type other than the RFLNA 221. This is not limited in this embodiment of this application.

In another example, the attenuation unit 222 may alternatively include N attenuation branches connected in parallel. As shown in FIG. 3, in the attenuation unit 222, each attenuation branch may include a first resistor and a second switch that are connected in series.

For example, a first attenuation branch may include a resistor R21 (that is, a first resistor) and a switch S21 (that is, a second switch) that are connected in series.

For another example, a second attenuation branch may include a resistor R22 (that is, a first resistor) and a switch S22 (that is, a second switch) that are connected in series.

For another example, an N^{th} attenuation branch may include a resistor R2N (that is, a first resistor) and a switch S2N (that is, a second switch) that are connected in series.

For example, first ends of the first resistors in the attenuation branches are electrically connected to be used as the first end of the attenuation unit 222. A second end of the first resistor in each attenuation branch is electrically connected to a first end of the corresponding switch, and second ends of switches in the attenuation branches are electrically connected to be used as the second end of the attenuation unit 222.

A first end of the attenuation unit 222 is electrically connected to the first end of the radio frequency receive circuit 221, may be used as an input end (that is, a second input end) of the gain adjustment unit 22, and is configured to receive the radio frequency signal VCOUP_P output by the first output end of the coupler 11. A second end of the amplification unit 221 may be used as one of output ends (that is, a third output end) of the gain adjustment unit 22, and is configured to output the radio frequency signal VCOUP_N1 to the dual balanced frequency mixer 3. A second end of the attenuation unit 222 may be used as another output end (that is, a fourth output end) of the gain adjustment unit 22, and is configured to output the radio frequency signal VCOUP_P1 to the dual balanced frequency mixer 3.

It may be figured out that the gain adjustment unit 22 may also selectively output the radio frequency signal VCOUP_N1 or the radio frequency signal VCOUP_P1 based on an application scenario of the radio frequency receive circuit 10. A phase difference between the radio frequency signal VCOUP_N1 and the radio frequency signal VCOUP_P1 may be 180 degrees. Because the radio frequency signal VCOUP_N1 and the radio frequency signal VCOUP_P1 have a same gain, the radio frequency signal VCOUP_N1 and the radio frequency signal VCOUP_P1 may be differential signals.

It can be further figured out that, in this embodiment of this application, multi-level attenuation of the gain of the radio frequency signal VCOUP _P may be implemented based on that at least one of the plurality of switches in the attenuation unit 222 is turned on. In other words, in this embodiment of this application, wide-range attenuation of the gain of the radio frequency signal VCOUP_P may be implemented, so that the second end of the attenuation unit 222 outputs a multi-level low-gain radio frequency signals VCOUP_P1.

The amplification unit 211 in the gain adjustment unit 21 may output the radio frequency signal (that is, the radio frequency signal VTH_N1) obtained through gain amplification, and the attenuation unit 212 in the gain adjustment unit 21 may output the radio frequency signal (that is, the radio frequency signal VTH_P1) obtained through gain attenuation. Similarly, the amplification unit 221 in the gain adjustment unit 22 may output the radio frequency signal (that is, the radio frequency signal VCOUP N1) obtained through gain amplification, and the attenuation unit 222 in the gain adjustment unit 22 may output the radio frequency signal (that is, the radio frequency signal VCOUP_P1) obtained through gain attenuation. Because the gain adjustment circuit 2 may selectively amplify or attenuate the gain of each radio frequency signal RF2, for the radio frequency receive circuit 100 shown in FIG. 3, the radio frequency signal RF3 may have the following four cases.

Case 1: The gain adjustment unit 21 and the gain adjustment unit 22 each output a radio frequency signal obtained through gain amplification. In this case, the radio frequency signal RF3 output by the gain adjustment circuit 2 may include the radio frequency signal VTH_N1 output by the amplification unit 211 and the radio frequency signal VCOUP_N1 output by the amplification unit 221. In other words, the gain adjustment circuit 2 may output two radio frequency signals obtained through gain amplification.

Case 2: The gain adjustment unit 21 and the gain adjustment unit 22 each output a radio frequency signal obtained through gain attenuation. In this case, the radio frequency signal RF3 output by the gain adjustment circuit 2 may include the radio frequency signal VTH_P1 output by the attenuation unit 212 and the radio frequency signal VCOUP_P1 output by the attenuation unit 222. In other words, the gain adjustment circuit 2 may output two radio frequency signals obtained through gain attenuation.

Case 3: The gain adjustment unit 21 outputs a radio frequency signal obtained through gain amplification, and the gain adjustment unit 22 outputs a radio frequency signal obtained through gain attenuation. In this case, the radio frequency signal RF3 output by the gain adjustment circuit 2 may include the radio frequency signal VTH_N1 output by the amplification unit 211 and the radio frequency signal VCOUP_P1 output by the attenuation unit 222. In other words, the gain adjustment circuit 2 may output the radio frequency signal obtained through gain amplification and the radio frequency signal obtained through gain attenuation.

Case 4: The gain adjustment unit 21 outputs a radio frequency signal obtained through gain attenuation, and the gain adjustment unit 22 outputs a radio frequency signal obtained through gain amplification. In this case, the radio frequency signal RF3 output by the gain adjustment circuit 2 may include the radio frequency signal VTH_P1 output by the attenuation unit 212 and the radio frequency signal VCOUP_N1 output by the amplification unit 221, as in Case 3. In other words, the gain adjustment circuit 2 may also output the radio frequency signal obtained through gain amplification and the radio frequency signal obtained through gain attenuation.

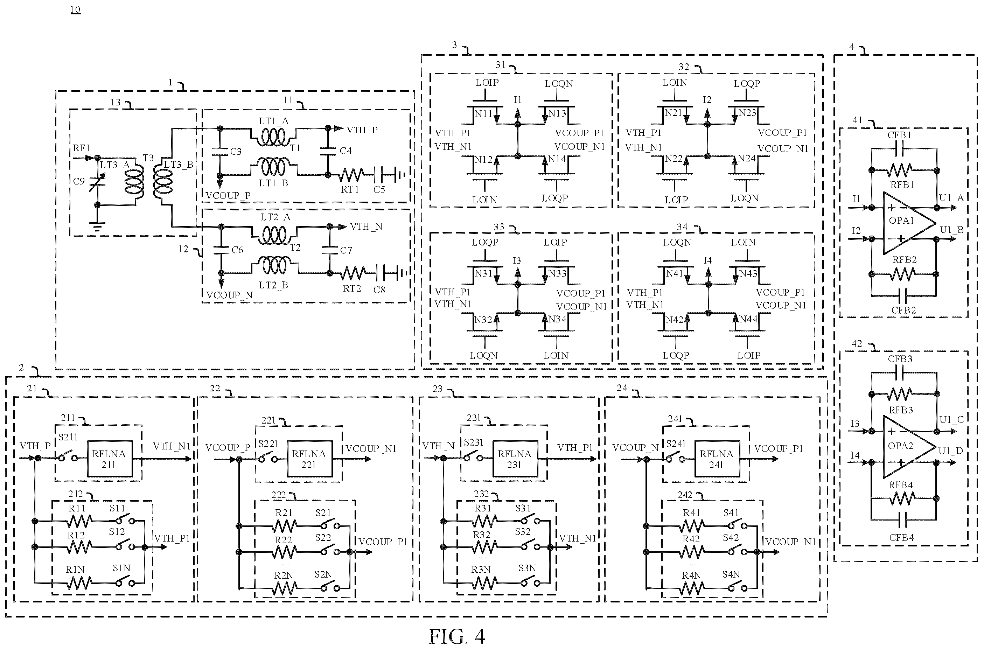

In some other embodiments, as shown in FIG. 4, the coupling circuit 1 may include a coupler 11 (that is, a first coupler), a coupler 12 (that is, a second coupler), and a conversion unit 13. For the coupler 11, also refer to the foregoing descriptions. Details are not described again in this embodiment of this application.

The conversion unit 13 may include a capacitor C9 (that is, a ninth capacitor) and a transformer T3 (that is, a third transformer). The transformer T3 may include a primary-side winding LT3_A (that is, a third primary-side winding) and a secondary-side winding LT3_B (that is, a third secondary-side winding) that are coupled to each other.

Optionally, a first end of the capacitor C9 is electrically connected to a first end of the primary-side winding LT3_A, and is used as a fourth input end of the conversion unit 13, that is, the input end of the coupling circuit 1. The fourth input end is configured to receive the radio frequency signal RF1. A second end of the capacitor C9 and a second end of the primary-side winding LT3_A are electrically connected to a ground end. A first end of the secondary-side winding LT3_B may be used as a seventh output end of the conversion unit 13, and the seventh output end is electrically connected to a first input end of the coupler 11. A second end of the secondary-side winding LT3_B is used as an eighth output end of the conversion unit 13, and the eighth output end is electrically connected to a third input end of the coupler 12.

Similar to the coupler 11, the coupler 12 may include a capacitor C6 (that is, a sixth capacitor), a capacitor C7 (that is, a seventh capacitor), a capacitor C8 (that is, an eighth capacitor), a matching resistor RT2 (that is, a second matching resistor), and a transformer T2 (that is, a second transformer). The transformer T2 may include a primary-side winding LT2_A (that is, a second primary-side winding) and a secondary-side winding LT2_B (that is, a second secondary-side winding) that are coupled to each other.

Optionally, one end of the capacitor C6 is electrically connected to a first end of the primary-side winding LT2_A, and is used as a third input end of the coupler 12. The third input end may be configured to be electrically connected to a second end of the secondary-side winding LT3_B. A first end of the capacitor C7 is electrically connected to a second end of the primary-side winding LT2_A, is used as a fifth output end of the coupler 12, and is configured to output the radio frequency signal VTH_N (that is, one radio frequency signal RF2). A second end of the capacitor C6 is electrically connected to a first end of the secondary-side winding LT2_B, is used as a sixth output end of the coupler 12, and is configured to output the radio frequency signal VCOUP_N (that is, another radio frequency signal RF2). A second end of the capacitor C7, a second end of the secondary-side winding LT2_B, and a first end of the matching resistor RT2 are electrically connected. A second end of the matching resistor RT2 is connected to a first end of the capacitor C7. A second end of the capacitor C7 is electrically connected to a ground end.

It can be learned that the radio frequency signal RF2 may include the radio frequency signal VTH_N, the radio frequency signal VCOUP_N, the radio frequency signal VTH_P, and the radio frequency signal VCOUP_P.

Because the coupling circuit 1 is electrically connected to the gain adjustment circuit 2, it may be figured out that the coupler 12 may output the radio frequency signal VCOUP_N and the radio frequency signal VTH_N to the gain adjustment circuit 2 through the fifth output end and the sixth output end. A phase difference between the radio frequency signal VCOUP_N and the radio frequency signal VTH_N may be 90 degrees. A phase difference between the radio frequency signal VTH_P and the radio frequency signal VTH_N may be 180 degrees. A phase difference between the radio frequency signal VCOUP_P and the radio frequency signal VCOUP_N may be 180 degrees. Because the radio frequency signal VTH_P and the radio frequency signal VTH_N have a same gain, the radio frequency signal VTH_P and the radio frequency signal VTH_N may be differential signals. Similarly, because the radio frequency signal VCOUP_P and the radio frequency signal VCOUP_N have a same gain, the radio frequency signal VCOUP_P and the radio frequency signal VCOUP_N may also be differential signals.

In this embodiment of this application, the coupler 11, the coupler 12, and the conversion unit 13 implement conversion from the radio frequency signal RF1 to the four radio frequency signals RF2, and output the four radio frequency signals RF2. In the four second radio frequency signals, the second radio frequency signal output by the first output end and the second radio frequency signal output by the fifth output end may be the differential signals, and the second radio frequency signal output by the second output end and the second radio frequency signal output by the sixth output end may also be the differential signals. Therefore, it may be considered that the coupling circuit uses a fully differential structure, so that an input second-order intercept point (input second-order intercept point, IIP2) can be increased, thereby improving an anti-interference capability of the radio frequency receive circuit.

Still refer to FIG. 4. The gain adjustment circuit 2 may include a gain adjustment unit 21 (that is, a first gain adjustment unit), a gain adjustment unit 22 (that is, a second gain adjustment unit), a gain adjustment circuit 23 (that is, a third gain adjustment unit), and a gain adjustment circuit 24 (that is, a fourth gain adjustment unit). In other words, the gain adjustment circuit 2 may include a plurality of gain adjustment units.

For the gain adjustment unit 21 and the gain adjustment unit 22, refer to the foregoing descriptions. Details are not described again in this embodiment of this application.

In an example, similar to the gain adjustment unit 21 and the gain adjustment unit 22, the gain adjustment circuit 23 may include an amplification unit 231 and an attenuation unit 232. The amplification unit 231 may include a switch S231 (that is, a first switch) and an RFLNA 231 that are connected in series.

A first end of the attenuation unit 232 and the switch S231 are used as second input ends of the gain adjustment unit 23, the RFLNA 211 is used as a third output end of the gain adjustment unit 23, and the second end of the attenuation unit 232 is used as a fourth output end of the gain adjustment unit 22.

The amplification unit 231 may be configured to: when the switch S231 is turned on, perform multi-level amplification on a gain of the radio frequency signal VTH_N through the RFLNA 231, and output a radio frequency signal VTH_P1. The attenuation unit 232 may be configured to: when the switch S231 is turned off, perform multi-level attenuation on the gain of the radio frequency signal VTH_N, and output a radio frequency signal VTH_N1.

In another example, the gain adjustment circuit 24 may include an amplification unit 241 and an attenuation unit 242. The amplification unit 241 may include a switch S241 (that is, a first switch) and an RFLNA 241 that are connected in series.

A first end of the attenuation unit 242 and the switch S241 are used as second input ends of the gain adjustment unit 24, the RFLNA 241 is used as a third output end of the gain adjustment unit 24, and the second end of the attenuation unit 242 is used as a fourth output end of the gain adjustment unit 24.

The amplification unit 241 may be configured to: when the switch S241 is turned on, perform multi-level amplification on a gain of the radio frequency signal VCOUP_N through the RFLNA 241, and output a radio frequency signal VCOUP_P1. The attenuation unit 242 may be configured to: when the switch S241 is turned off, perform multi-level attenuation on the gain of the radio frequency signal VCOUP_N, and output a radio frequency signal VCOUP_N1.

Similar to the attenuation unit 212 and the attenuation unit 222 in FIG. 3, both the attenuation unit 232 and the attenuation unit 242 in FIG. 4 may include N parallel attenuation branches. In the attenuation unit 232 and the attenuation unit 242, each attenuation branch may include a first resistor and a second switch that are connected in series.

For example, in the attenuation unit 232, a first attenuation branch may include a resistor R31 (that is, a first resistor) and a switch S31 (that is, a second switch) that are connected in series. A second attenuation branch may include a resistor R32 (that is, a first resistor) and a switch S32 (that is, a second switch) that are connected in series. An N^{th} attenuation branch may include a resistor R3N (that is, a first resistor) and a switch S3N (that is, a second switch) that are connected in series.

For another example, in the attenuation unit 242, a first attenuation branch may include a resistor R41 (that is, a first resistor) and a switch S41 (that is, a second switch) that are connected in series. A second attenuation branch may include a resistor R42 (that is, a first resistor) and a switch S42 (that is, a second switch) that are connected in series. An N^{th} attenuation branch may include a resistor R4N (that is, a first resistor) and a switch S4N (that is, a second switch) that are connected in series.

For example, in the attenuation unit 232, first ends of the first resistors in the attenuation branches are electrically connected to be used as the first end of the attenuation unit 232. A second end of the first resistor in each attenuation branch is electrically connected to a first end of the corresponding switch, and second ends of switches in the attenuation branches are electrically connected to be used as the second end of the attenuation unit 232.

A first end of the attenuation unit 232 is electrically connected to the first end of the radio frequency receive circuit 231, may be used as an input end (that is, a second input end) of the gain adjustment unit 23, and is configured to receive the radio frequency signal VTH_N output by the fifth output end of the coupler 12. A second end of the amplification unit 231 may be used as one of output ends (that is, a third output end) of the gain adjustment unit 23, and is configured to output the radio frequency signal VTH_P1 to the dual balanced frequency mixer 3. A second end of the attenuation unit 232 may be used as another output end (that is, a fourth output end) of the gain adjustment unit 23, and is configured to output the radio frequency signal VTH_N1 to the dual balanced frequency mixer 3.

Similarly, in the attenuation unit 242, first ends of the first resistors in the attenuation branches are electrically connected to be used as the first end of the attenuation unit 242. A second end of the first resistor in each attenuation branch is electrically connected to a first end of the corresponding switch, and second ends of switches in the attenuation branches are electrically connected to be used as the second end of the attenuation unit 242.

A first end of the attenuation unit 242 is electrically connected to the first end of the radio frequency receive circuit 241, may be used as an input end (that is, a second input end) of the gain adjustment unit 24, and is configured to receive the radio frequency signal VCOUP_N output by the sixth output end of the coupler 12. A second end of the amplification unit 241 may be used as one of output ends (that is, a third output end) of the gain adjustment unit 24, and is configured to output the radio frequency signal VCOUP_P1 to the dual balanced frequency mixer 3. A second end of the attenuation unit 242 may be used as another output end (that is, a fourth output end) of the gain adjustment unit 24, and is configured to output the radio frequency signal VCOUP_N1 to the dual balanced frequency mixer 3.

It may be figured out that based on an application scenario of the radio frequency receive circuit 10, the gain adjustment unit 23 may selectively output the radio frequency signal VTH_N1 or the radio frequency signal VTH_P1, and the gain adjustment unit 24 may selectively output the radio frequency signal VCOUP_N1 or the radio frequency signal VCOUP_P1. A phase difference between the radio frequency signal VTH_N1 and the radio frequency signal VTH_P1 may be 180 degrees, and a phase difference between the radio frequency signal VCOUP_N1 and the radio frequency signal VCOUP_P1 may also be 180 degrees. Because the radio frequency signal VTH_N1 and the radio frequency signal VTH_P1 have a same gain, and the radio frequency signal VCOUP_N1 and the radio frequency signal VCOUP_P1 have a same gain, the radio frequency signal VTH_N1 and the radio frequency signal VTH_P1 may be differential signals, and the radio frequency signal VCOUP_N1 and the radio frequency signal VCOUP_P1 may also be differential signals.

It can be figured out that, in this embodiment of this application, multi-level attenuation of the gain of the radio frequency signal VTH_N may be implemented based on that at least one of the plurality of switches in the attenuation unit 232 is turned on. In other words, in this embodiment of this application, wide-range attenuation of the gain of the radio frequency signal VTH_N can be implemented, so that the second end of the attenuation unit 232 outputs the multi-level low-gain radio frequency signal VTH_N1. In this embodiment of this application, multi-level attenuation of the gain of the radio frequency signal VCOUP_N may be further implemented based on that at least one of the plurality of switches in the attenuation unit 242 is turned on. In other words, in this embodiment of this application, wide-range attenuation of the gain of the radio frequency signal VCOUP_N can be implemented, so that the second end of the attenuation unit 242 outputs the multi-level low-gain radio frequency signal VCOUP_N1.

Further, the amplification unit 211, the amplification unit 221, the amplification unit 231, and the amplification unit 241 may all use a radio frequency low noise amplifier. Certainly, the four amplification units may alternatively be amplifiers of another type. This is not limited in this embodiment of this application.

It may be understood that the gain adjustment unit 21, the gain adjustment unit 22, the gain adjustment unit 23, and the gain adjustment unit 24 each may output the radio frequency signal obtained through gain amplification. The gain adjustment unit 21, the gain adjustment unit 22, the gain adjustment unit 23, and the gain adjustment unit 24 each may output the radio frequency signal obtained through gain attenuation. Because the gain adjustment circuit 2 may selectively amplify or attenuate the gain of each radio frequency signal RF2, for the radio frequency receive circuit 100 shown in FIG. 4, the radio frequency signal RF3 may have the following several cases.

Case 1: The gain adjustment unit 21, the gain adjustment unit 22, the gain adjustment unit 23, and the gain adjustment unit 24 each output the radio frequency signal obtained through gain amplification. In this case, the radio frequency signal RF3 output by the gain adjustment circuit 2 may include the radio frequency signal VTH_N1 output by the amplification unit 211, the radio frequency signal VCOUP_N1 output by the amplification unit 221, the radio frequency signal VTH_P1 output by the amplification unit 231, and the radio frequency signal VCOUP_P1 output by the amplification unit 241. In other words, the gain adjustment circuit 2 may output four radio frequency signals obtained through gain amplification.

Case 2: The gain adjustment unit 21, the gain adjustment unit 22, the gain adjustment unit 23, and the gain adjustment unit 24 each output the radio frequency signal obtained through gain attenuation. In this case, the radio frequency signal RF3 output by the gain adjustment circuit 2 may include the radio frequency signal VTH_P1 output by the attenuation unit 212, the radio frequency signal VCOUP_P1 output by the attenuation unit 222, the radio frequency signal VTH_N1 output by the attenuation unit 232, and the radio frequency signal VCOUP_N1 output by the attenuation unit 242. In other words, the gain adjustment circuit 2 may output four radio frequency signals obtained through gain attenuation.

Case 3: Some of the gain adjustment unit 21, the gain adjustment unit 22, the gain adjustment unit 23, and the gain adjustment unit 24 output the radio frequency signal obtained through gain amplification, and the other gain adjustment units output the radio frequency signal obtained through gain attenuation. In this case, the gain adjustment circuit 2 may output the radio frequency signal obtained through gain amplification and the radio frequency signal obtained through gain attenuation.

For example, the gain adjustment unit 21 outputs the radio frequency signal obtained through gain amplification, and the gain adjustment unit 22, the gain adjustment unit 23, and the gain adjustment unit 24 each output the radio frequency signal obtained through gain attenuation. In this case, the radio frequency signal RF3 output by the gain adjustment circuit 2 may include the radio frequency signal VTH_N1 output by the amplification unit 211, the radio frequency signal VCOUP_P1 output by the attenuation unit 222, the radio frequency signal VTH_N1 output by the attenuation unit 232, and the radio frequency signal VCOUP_N1 output by the attenuation unit 242.

For another example, the gain adjustment unit 21 and the gain adjustment unit 24 each may output the radio frequency signal obtained through gain amplification, and the gain adjustment unit 22 and the gain adjustment unit 23 each may output the radio frequency signal obtained through gain attenuation. In this case, the radio frequency signal RF3 output by the gain adjustment circuit 2 may include the radio frequency signal VTH_N1 output by the amplification unit 211, the radio frequency signal VCOUP_P1 output by the amplification unit 242, the radio frequency signal VCOUP_P1 output by the attenuation unit 222, and the radio frequency signal VTH_N1 output by the attenuation unit 232.

For example, topological structures of the amplification unit 211, the amplification unit 221, the amplification unit 231, and the amplification unit 241 (referred to as an amplification unit below) may be the same or may be different. In this embodiment of this application, the topological structures of the amplification unit 211, the amplification unit 221, the amplification unit 231, and the amplification unit 241 may be the same. The following uses the amplification unit 211 as an example to describe the topology structure of the amplification unit.

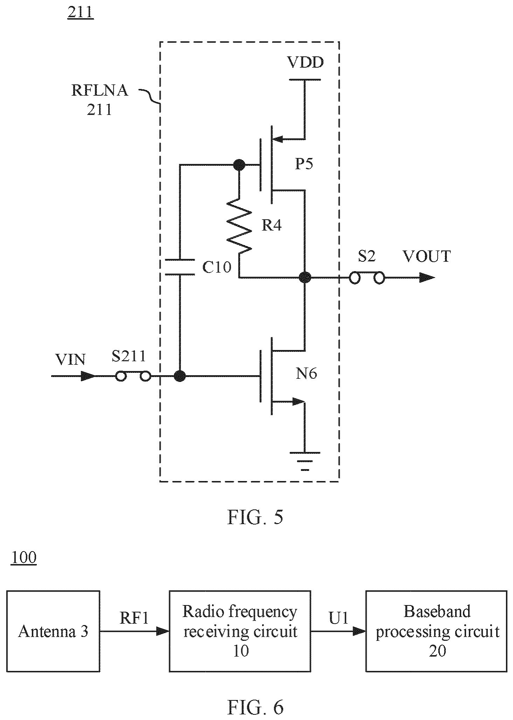

As shown in FIG. 5, the amplification unit 211 may include a switch S211 and an RFLNA 211. The RFLNA 211 may include a switching transistor P5 (that is, a fifth switching transistor), a switching transistor N6 (that is, a sixth switching transistor), a resistor R4 (that is, a fourth resistor), and a capacitor C10 (that is, a tenth capacitor). A control electrode of the switching transistor P5 may be electrically connected to a first end of the resistor R4, a first electrode of the switching transistor P5 may be configured to receive an operating voltage VDD, and a second electrode of the switching transistor P5, a first electrode of the switching transistor N6, and a second end of the resistor R4 are electrically connected, are used as an output end of the RFLNA 211, that is, an output end VOUT of the amplification unit 211. A first end of the capacitor C10 may be electrically connected to a control electrode of the switching transistor P5, a second end of the capacitor C10 may be electrically connected to a control electrode of the switching transistor N6, and both are electrically connected to a second end of the switch S211. A first end of the switch S211 may be used as an input end VIN of the amplification unit 211. A second electrode of the switching transistor N6 is electrically connected to a ground end. The amplification unit 211 may further dispose a switch S2 at an output end of the RFLNA 211, to control output of the amplified radio frequency signal.

Further, the switching transistor P5 may be a P-type metal-oxide-semiconductor field-effect transistor (metal-oxide-semiconductor field-effect transistor, MOSFET), that is, a PMOS transistor. The switching transistor N6 may be an N-type metal-oxide-semiconductor field-effect transistor, that is, an NMOS transistor. Certainly, the switching transistor P5 and the switching transistor N6 each may alternatively be another semiconductor device. This is not limited in this embodiment of this application.

In some other embodiments, as shown in FIG. 3 and FIG. 4, the dual balanced frequency mixer 3 may include a frequency mixing unit 31 (that is, a first frequency mixing unit), a frequency mixing unit 32 (that is, a second frequency mixing unit), a frequency mixing unit 33 (that is, a third frequency mixing unit), and a frequency mixing unit 34 (that is, a fourth frequency mixing unit). In other words, the dual balanced frequency mixer 3 may include a plurality of frequency mixing units.

Optionally, each frequency mixing unit may include four switching transistors, and control electrodes of all the four switching transistors may be configured to receive a local oscillation signal. First electrodes of the four switching transistors may be electrically connected to the gain adjustment circuit 2. Second electrodes of the four switching transistors may be electrically connected, and are used as an output end of the frequency mixing unit.

For example, all the four switching transistors may be NMOS transistors. Certainly, the four switching transistors each may alternatively be a semiconductor device of another type. This is not limited in this embodiment of this application.

In an example, the frequency mixing unit 31 may include a switching transistor N11, a switching transistor N12, a switching transistor N13, and a switching transistor N14. A control electrode of the switching transistor N11 may be configured to receive a local oscillation in-phase positive signal LOIP. A control electrode of the switching transistor N12 may be configured to receive a local oscillation in-phase negative signal LOIN. A control electrode of the switching transistor N13 may be configured to receive a local oscillation quadrature negative signal LOQN. A control electrode of the switching transistor N14 may be configured to receive a local oscillation quadrature positive signal LOQP.

In another example, the frequency mixing unit 32 may include a switching transistor N21, a switching transistor N22, a switching transistor N23, and a switching transistor N24. A control electrode of the switching transistor N21 may be configured to receive a local oscillation in-phase negative signal LOIN. A control electrode of the switching transistor N22 may be configured to receive a local oscillation in-phase positive signal LOIP. A control electrode of the switching transistor N23 may be configured to receive a local oscillation quadrature positive signal LOQP. A control electrode of the switching transistor N24 may be configured to receive a local oscillation quadrature negative signal LOQN.

In another example, the frequency mixing unit 33 may include a switching transistor N31, a switching transistor N32, a switching transistor N33, and a switching transistor N34. A control electrode of the switching transistor N31 may be configured to receive a local oscillation quadrature positive signal LOQP. A control electrode of the switching transistor N32 may be configured to receive a local oscillation quadrature negative signal LOQN. A control electrode of the switching transistor N33 may be configured to receive a local oscillation in-phase positive signal LOIP. A control electrode of the switching transistor N34 may be configured to receive a local oscillation in-phase negative signal LOIN.

In another example, the frequency mixing unit 34 may include a switching transistor N41, a switching transistor N42, a switching transistor N43, and a switching transistor N44. A control electrode of the switching transistor N41 may be configured to receive a local oscillation quadrature negative signal LOQN. A control electrode of the switching transistor N42 may be configured to receive a local oscillation quadrature positive signal LOQP. A control electrode of the switching transistor N43 may be configured to receive a local oscillation in-phase negative signal LOIN. A control electrode of the switching transistor N44 may be configured to receive a local oscillation in-phase positive signal LOIP.

For example, as shown in FIG. 3 and FIG. 4, drains (that is, first electrodes) of the switching transistor N11, the switching transistor N21, the switching transistor N31, and the switching transistor N41 may be electrically connected to a fourth output end of the gain adjustment unit 21. Drains of the switching transistor N12, the switching transistor N22, the switching transistor N32, and the switching transistor N42 may be electrically connected to the third output end of the gain adjustment unit 21. Drains of the switching transistor N13, the switching transistor N23, the switching transistor N33, and the switching transistor N43 may be electrically connected to the fourth output end of the gain adjustment unit 22. Drains of the switching transistor N14, the switching transistor N24, the switching transistor N34, and the switching transistor N44 may be electrically connected to the third output end of the gain adjustment unit 22.

Sources (that is, second electrodes) of the switching transistor N11, the switching transistor N12, the switching transistor N13, and the switching transistor N14 may be electrically connected, and are used as an output end of the frequency mixing unit 31 to output a current signal I1. Similarly, sources (that is, second electrodes) of the switching transistor N21, the switching transistor N22, the switching transistor N23, and the switching transistor N24 may be electrically connected, and are used as an output end of the frequency mixing unit 32 to output a current signal I2. Sources (that is, second electrodes) of the switching transistor N31, the switching transistor N32, the switching transistor N33, and the switching transistor N34 may be electrically connected, and are used as an output end of the frequency mixing unit 33 to output a current signal I3. Sources (that is, second electrodes) of the switching transistor N41, the switching transistor N42, the switching transistor N43, and the switching transistor N44 may be electrically connected, and are used as an output end of the frequency mixing unit 34 to output a current signal I4.

It can be learned that, in FIG. 3, each switching transistor in each frequency mixing unit may be turned on or off based on a local oscillation signal received by the control electrode, so that each frequency mixing unit may adjust a frequency of each radio frequency signal RF3 through the four switching transistors, and output a current signal I. In other words, each frequency mixing unit may control on and off of the four switching transistors based on a frequency of the local oscillation signal, to implement conversion from the radio frequency signal RF3 to the current signal I.

Further, as shown in FIG. 4, drains (that is, first electrodes) of the switching transistor N11, the switching transistor N21, the switching transistor N31, and the switching transistor N41 may be electrically connected to the third output end of the gain adjustment unit 23. Drains of the switching transistor N12, the switching transistor N22, the switching transistor N32, and the switching transistor S42 may be further electrically connected to the fourth output end of the gain adjustment unit 23. Drains of the switching transistor N13, the switching transistor N23, the switching transistor N33, and the switching transistor N43 may be further electrically connected to the third output end of the gain adjustment unit 24. Drains of the switching transistor N14, the switching transistor N24, the switching transistor N34, and the switching transistor N44 may be electrically connected to the fourth output end of the gain adjustment unit 24.

It can be learned that, in this embodiment of this application, the dual balanced frequency mixer 3 may output four current signals I based on the radio frequency signals RF3 output by the gain adjustment unit 31, the gain adjustment unit 32, the gain adjustment unit 33, and the gain adjustment unit 34.

In a possible implementation, refer to FIG. 3 and FIG. 4. The conversion circuit 4 may include a transimpedance amplification unit 41 (that is, a first transimpedance amplification unit) and a transimpedance amplification unit 42 (that is, a second transimpedance amplification unit).

The transimpedance amplification unit 41 may include an amplification unit OPA1 (that is, a second amplification unit), a feedback capacitor CFB1 (that is, a first capacitor), a feedback resistor RFB1 (that is, a second resistor), a feedback capacitor CFB2 (that is, a second capacitor), and a feedback resistor RFB2. (that is, the third resistor). The amplification unit OPA1 includes two input ends and two output ends. The two input ends may include a fifth input end and a sixth input end, and the two output ends may include a ninth output end and a tenth output end.

Optionally, a first end of each of the feedback capacitor CFB1 and the feedback resistor RFB1 may be configured to be electrically connected to the fifth input end of the amplification unit OPA1. A second end of each of the feedback capacitor CFB1 and the feedback resistor RFB1 may be configured to be electrically connected to the ninth output end of the amplification unit OPA1. In other words, the feedback capacitor CFB1 and the feedback resistor RFB1 may be bridged between the fifth input end and the ninth output end of the amplification unit OPA1.

Similarly, a first end of each of the feedback capacitor CFB2 and the feedback resistor RFB2 may be configured to be electrically connected to the sixth input end of the amplification unit OPA1. A second end of each of the feedback capacitor CFB2 and the feedback resistor RFB2 may be configured to be electrically connected to the tenth output end of the amplification unit OPA1. In other words, the feedback capacitor CFB 2 and the feedback resistor RFB 2 may be bridged between the sixth input end and the tenth output end of the amplification unit OPA1.

For example, the fifth input end of the amplification unit OPA1 may be configured to be electrically connected to the output end of the frequency mixing unit 31, and the fifth input end of the amplification unit OPA1 may be configured to receive the current signal I1 output by the frequency mixing unit 31. Similarly, the sixth input end of the amplification unit OPA1 may be configured to be electrically connected to the output end of the frequency mixing unit 32, and the sixth input end of the amplification unit OPA1 may be configured to receive the current signal I2 output by the frequency mixing unit 32. The ninth output end of the amplification unit OPA1 may be configured to output a voltage signal U1_A, and the tenth output end of the amplification unit OPA1 may be configured to output a voltage signal U1_B.

The fifth input end of the amplification unit OPA1 and the tenth output end of the amplification unit OPA1 may have a same phase, and the sixth input end of the amplification unit OPA1 and the ninth output end of the amplification unit OPA1 may also have a same phase.

It can be learned that, in this embodiment of this application, the transimpedance amplification unit 41 can implement conversion from the current signal I1 and the current signal I2 to the voltage signal U1_A and the voltage signal U1_B, and can output the two voltage signals.

Similar to the transimpedance amplification unit 41, the transimpedance amplification unit 42 may include an amplification unit OPA2 (that is, a second amplification unit), a feedback capacitor CFB3 (that is, a first capacitor), a feedback resistor RFB3 (that is, a second resistor), a feedback capacitor CFB4 (that is, a second capacitor), and a feedback resistor RFB4 (that is, a third resistor). The amplification unit OPA2 also includes two input ends and two output ends. The two input ends may include a fifth input end and a sixth input end, and the two output ends may include a ninth output end and a tenth output end.

Optionally, a first end of each of the feedback capacitor CFB3 and the feedback resistor RFB3 may be configured to be electrically connected to the fifth input end of the amplification unit OPA2, and a second end of each of the feedback capacitor CFB3 and the feedback resistor RFB3 may be configured to be electrically connected to the ninth output end of the amplification unit OPA2. In other words, the feedback capacitor CFB1 and the feedback resistor RFB1 may be bridged between the fifth input end and the ninth output end of the amplification unit OPA1.

Similarly, a first end of each of the feedback capacitor CFB4 and the feedback resistor RFB4 may be configured to be electrically connected to the sixth input end of the amplification unit OPA2, and a second end of each of the feedback capacitor CFB4 and the feedback resistor RFB4 may be configured to be electrically connected to the tenth output end of the amplification unit OPA2. In other words, the feedback capacitor CFB4 and the feedback resistor RFB4 may be bridged between the sixth input end and the tenth output end of the amplification unit OPA1.

For example, the fifth input end of the amplification unit OPA2 may be configured to be electrically connected to the output end of the frequency mixing unit 33, and the fifth input end of the amplification unit OPA2 may be configured to receive the current signal I3 output by the frequency mixing unit 33. Similarly, the sixth input end of the amplification unit OPA2 may be configured to be electrically connected to the output end of the frequency mixing unit 34, and the sixth input end of the amplification unit OPA2 may be configured to receive the current signal I4 output by the frequency mixing unit 34. The ninth output end of the amplification unit OPA2 may be configured to output a voltage signal U1_C, and the tenth output end of the amplification unit OPA2 may be configured to output a voltage signal U1_D.

The fifth input end of the amplification unit OPA2 and the tenth output end of the amplification unit OPA2 may have a same phase, and the sixth input end of the amplification unit OPA2 and the ninth output end of the amplification unit OPA2 may also have a same phase.

It can be learned that, in this embodiment of this application, the transimpedance amplification unit 42 may convert the current signal I3 and the current signal I4 into the voltage signal U1_C and the voltage signal U1_D, and may output the two voltage signals.

In conclusion, in this embodiment of this application, the transimpedance amplification module 4 may implement conversion from the current signal I1, the current signal I2, the current signal I3, and the current signal I4 to the voltage signal U1_A, the voltage signal U1_B, the voltage signal U1_C, and the voltage signal U1_D, and output the four voltage signals.

For example, both the amplification unit OPA1 and the amplification unit OPA2 may be operational amplifiers (operational amplifier, OPA). Certainly, the amplification unit OPA1 and the amplification unit OPA2 may alternatively be amplifiers of another type. This is not limited in this embodiment of this application.

The radio frequency receive circuit 10 provided in this embodiment of this application implements, through the gain adjustment circuit 2, flexible switching between a high gain and a multi-level low gain of the radio frequency signal RF2, and has a noise cancellation function for the matching resistor RT1 and the matching resistor RT2, so that the radio frequency receive circuit 10 has low noise performance. In addition, the radio frequency receive circuit 10 has high linearity performance, thereby improving error vector magnitude (error vector magnitude, EVM) performance of the radio frequency receive circuit 10.

An embodiment of this application provides a receiver, as shown in FIG. 6. The receiver 100 may include a radio frequency receive circuit 10, a baseband processing circuit 20, and an antenna 30. The antenna 30 may be electrically connected to an input end (which may be the first input end of the coupler 11 in FIG. 3, or may be the fourth input end of the conversion unit 13 in FIG. 4) of the radio frequency receive circuit 10. An output end of the radio frequency receive circuit 10 (which may include the ninth output end of the amplification unit OPA1, the tenth output end of the amplification unit OPA1, the ninth output end of the amplification unit OPA2, and the tenth output end of the amplification unit OPA2 in FIG. 3 and FIG. 4) may be electrically connected to an input end of the baseband processing circuit 20.

The antenna 30 may be configured to send a radio frequency signal RF1 to the radio frequency receive circuit 10.

The baseband processing circuit 20 may be configured to: filter and convert a voltage signal U1 sent by the radio frequency receive circuit 10, and output a voltage signal U2 (that is, a second voltage signal). The voltage signal U2 may be used to indicate a voltage signal obtained through filtering and conversion

Optionally, the baseband processing circuit 20 may perform filtering and analog-to-digital conversion on the voltage signal U1. Therefore, the voltage signal U1 may be an analog voltage signal, and the voltage signal U2 may be a voltage signal obtained through filtering and analog-to-digital conversion, that is, a filtered digital voltage signal.

Optionally, the receiver 100 may be used in a seventh generation wireless network whose radio frequency bandwidth is 320 MHz and whose modulation scheme is 4KQAM. A gain Gain, an input third-order intercept point (input third-order intercept point, IIP3), and a noise factor (noise factor, NF) are shown in Table 1.

**Table 1**

| Level | Gain (dB) | IIP3 (dBm) | NF (dB) |
|---|---|---|---|
| G5 | 27 | 5 | 6 |
| G4 | 22 | 8 | 9 |
| G3 | 17 | 16 | 12 |
| G2 | 11 | 21 | 15 |
| G1 | 6 | 28 | 19 |
| G0 | -1 | 32 | 24 |

It can be learned from the gain Gain in Table 1 that the levels G5 and G4 are high gain levels, and the levels G3, G2, G1, and G0 are low gain levels. In other words, the receiver 100 provided in this embodiment of this application can implement multi-level switching of a radio frequency signal between a high gain and a low gain. A noise factor NF corresponding to a level G0 is 24 dB, which is greater than a noise factor NF corresponding to levels G1 to G5. In comparison with a noise factor of 30 dB in a related technology, the receiver 100 provided in this embodiment of this application has low noise performance.

It can be further learned from Table 1 that the input third-order intercept point of the receiver 100 provided in this embodiment of this application may reach 32 dBm, so that an anti-interference capability of the receiver 100 can be improved.

In addition, the receiver 100 provided in this embodiment of this application can implement error vector magnitude performance higher than -46 dB. In comparison with error vector magnitude performance of -41 dB in the related technology, in this embodiment of this application, error vector magnitude performance can be improved by more than 5 dB.

An embodiment of this application provides an electronic device, which may include the foregoing receiver.

Optionally, the electronic device may be a radio frequency device such as a mobile phone or a router. Certainly, the electronic device may alternatively be another device. This is not limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A radio frequency receive circuit, comprising a coupling circuit, a gain adjustment circuit, and a dual balanced frequency mixer, wherein
the coupling circuit is configured to: convert a first radio frequency signal into at least two second radio frequency signals, and output the at least two second radio frequency signals to the gain adjustment circuit;
the gain adjustment circuit is configured to: selectively amplify or attenuate a gain of each of the at least two second radio frequency signals, and output at least two third radio frequency signals to the dual balanced frequency mixer; and
the dual balanced frequency mixer is configured to mix the at least two third radio frequency signals based on a local oscillation signal.

2. The radio frequency receive circuit according to claim 1, wherein the coupling circuit comprises a first coupler, and the first coupler comprises a first input end, a first output end, and a second output end;
the first input end is configured to receive the first radio frequency signal, and the first output end and the second output end are configured to be electrically connected to the gain adjustment circuit; and
a phase difference between a second radio frequency signal output by the first output end and a second radio frequency signal output by the second output end is 90 degrees.

3. The radio frequency receive circuit according to claim 2, wherein the gain adjustment circuit comprises a plurality of gain adjustment units, and the plurality of gain adjustment units comprise a first gain adjustment unit and a second gain adjustment unit;
each of the plurality of gain adjustment units comprises a second input end, a third output end, and a fourth output end;
a second input end of the first gain adjustment unit is configured to be electrically connected to the first output end, a second input end of the second gain adjustment unit is configured to be electrically connected to the second output end, and a third output end of the first gain adjustment unit, a fourth output end of the first gain adjustment unit, a third output end of the second gain adjustment unit, and a fourth output end of the second gain adjustment unit are all configured to be electrically connected to the dual balanced frequency mixer; and
a phase difference between a third radio frequency signal output by the third output end and a third radio frequency signal output by the fourth output end is 180 degrees.

4. The radio frequency receive circuit according to claim 1, wherein the coupling circuit comprises a first coupler, a second coupler, and a conversion unit;
the first coupler comprises a first input end, a first output end, and a second output end, the second coupler comprises a third input end, a fifth output end, and a sixth output end, and the conversion unit comprises a fourth input end, a seventh output end, and an eighth output end;
the fourth input end is configured to receive the first radio frequency signal, the seventh output end is configured to be electrically connected to the first input end, the eighth output end is configured to be electrically connected to the third input end, and the first output end, the second output end, the fifth output end, and the sixth output end are configured to be electrically connected to the gain adjustment circuit;
a phase difference between a second radio frequency signal output by the first output end and a second radio frequency signal output by the second output end is 90 degrees, a phase difference between a second radio frequency signal output by the fifth output end and a second radio frequency signal output by the sixth output end is 90 degrees, a phase difference between the second radio frequency signal output by the first output end and the second radio frequency signal output by the fifth output end is 180 degrees, and a phase difference between the second radio frequency signal output by the second output end and the second radio frequency signal output by the sixth output end is 180 degrees.

5. The radio frequency receive circuit according to claim 4, wherein the gain adjustment circuit comprises a plurality of gain adjustment units, and the plurality of gain adjustment units comprise a first gain adjustment unit, a second gain adjustment unit, a third gain adjustment unit, and a fourth gain adjustment unit;
each of the plurality of gain adjustment units comprises a second input end, a third output end, and a fourth output end;
a second input end of the first gain adjustment unit is configured to be electrically connected to the first output end, a second input end of the second gain adjustment unit is configured to be electrically connected to the second output end, a second input end of the third gain adjustment unit is configured to be electrically connected to the fifth output end, a second input end of the fourth gain adjustment unit is configured to be electrically connected to the sixth output end, and a third output end of the first gain adjustment unit, a fourth output end of the first gain adjustment unit, a third output end of the second gain adjustment unit, a fourth output end of the second gain adjustment unit, a third output end of the third gain adjustment unit, a fourth output end of the third gain adjustment unit, a third output end of the fourth gain adjustment unit, and a fourth output end of the fourth gain adjustment unit are all configured to be electrically connected to the frequency mixing module; and
a phase difference between a third radio frequency signal output by the third output end and a third radio frequency signal output by the fourth output end is 180 degrees.

6. The radio frequency receive circuit according to claim 3 or 5, wherein each gain adjustment unit comprises a first amplification unit and an attenuation unit, and the first amplification unit comprises a first switch and a radio frequency low noise amplifier that are connected in series;
a first end of the attenuation unit and the first switch are used as the second input end of each gain adjustment unit, the radio frequency low noise amplifier is used as the third output end of each gain adjustment unit, and a second end of the attenuation unit is used as the fourth output end of each gain adjustment unit;
the first amplification unit is configured to: when the first switch is turned on, perform multi-level amplification on a gain of the second radio frequency signal through the radio frequency low noise amplifier, and output an amplified radio frequency signal; and
the attenuation unit is configured to: when the first switch is turned off, perform multi-level attenuation on the gain of the second radio frequency signal, and output an attenuated radio frequency signal.

7. The radio frequency receive circuit according to claim 6, wherein the attenuation unit comprises a plurality of attenuation branches connected in parallel, and each of the plurality of attenuation branches comprises a first resistor and a second switch that are connected in series.

8. The radio frequency receive circuit according to claim 3 or 5, wherein the dual balanced frequency mixer comprises a plurality of frequency mixing units;
each of the plurality of frequency mixing units comprises a first switching transistor, a second switching transistor, a third switching transistor, and a fourth switching transistor; and
control electrodes of the first switching transistor, the second switching transistor, the third switching transistor, and the fourth switching transistor are all configured to receive the local oscillation signal; first electrodes of the first switching transistor, the second switching transistor, the third switching transistor, and the fourth switching transistor are configured to be electrically connected to the gain adjustment circuit; and second electrodes of the first switching transistor, the second switching transistor, the third switching transistor, and the fourth switching transistor are electrically connected, and are used as an output end of the frequency mixing unit.

9. The radio frequency receive circuit according to claim 8, wherein the local oscillation signal comprises a local oscillation in-phase positive signal LOIP, a local oscillation in-phase negative signal LOIN, a local oscillation quadrature positive signal LOQP, and a local oscillation quadrature negative signal LOQN.

10. The radio frequency receive circuit according to claim 9, wherein the plurality of frequency mixing units comprise a first frequency mixing unit, a second frequency mixing unit, a third frequency mixing unit, and a fourth frequency mixing unit;
a control electrode of a first switching transistor in the first frequency mixing unit, a control electrode of a second switching transistor in the second frequency mixing unit, a control electrode of a third switching transistor in the third frequency mixing unit, and a control electrode of a fourth switching transistor in the fourth frequency mixing unit are all configured to receive the local oscillation in-phase positive signal LOIP; a control electrode of a second switching transistor in the first frequency mixing unit, a control electrode of a first switching transistor in the second frequency mixing unit, a control electrode of a fourth switching transistor in the third frequency mixing unit, and a control electrode of a third switching transistor in the fourth frequency mixing unit are all configured to receive the local oscillation in-phase negative signal LOIN; a control electrode of a fourth switching transistor in the first frequency mixing unit, a control electrode of a third switching transistor in the second frequency mixing unit, a control electrode of a first switching transistor in the third frequency mixing unit, and a control electrode of a second switching transistor in the fourth frequency mixing unit are all configured to receive the local oscillation quadrature positive signal LOQP; and a control electrode of a third switching transistor in the first frequency mixing unit, a control electrode of a fourth switching transistor in the second frequency mixing unit, a control electrode of a second switching transistor in the third frequency mixing unit, and a control electrode of a first switching transistor in the fourth frequency mixing unit are all configured to receive the local oscillation quadrature negative signal LOQN; and
a first electrode of the first switching transistor in each frequency mixing unit is configured to be electrically connected to the fourth output end of the first gain adjustment unit, a first electrode of the second switching transistor in each frequency mixing unit is configured to be electrically connected to the third output end of the first gain adjustment unit, a first electrode of the third switching transistor in each frequency mixing unit is configured to be electrically connected to the fourth output end of the second gain adjustment unit, and a first electrode of the fourth switching transistor in each frequency mixing unit is configured to be electrically connected to the third output end of the second gain adjustment unit.

11. The radio frequency receive circuit according to claim 10, wherein the first electrode of the first switching transistor in each frequency mixing unit is further configured to be electrically connected to the third output end of the third gain adjustment unit, the first electrode of the second switching transistor in each frequency mixing unit is further configured to be electrically connected to the fourth output end of the third gain adjustment unit, the first electrode of the third switching transistor in each frequency mixing unit is further configured to be electrically connected to the third output end of the fourth gain adjustment unit, and the first electrode of the fourth switching transistor in each frequency mixing unit is further configured to be electrically connected to the fourth output end of the fourth gain adjustment unit.

12. The radio frequency receive circuit according to any one of claims 9 to 11, wherein a phase difference between the local oscillation quadrature positive signal LOQP and the local oscillation in-phase positive signal LOIP is 90 degrees, a phase difference between the local oscillation in-phase negative signal LOIN and the local oscillation in-phase positive signal LOIP is 180 degrees, and a phase difference between the local oscillation quadrature negative signal LOQN and the local oscillation in-phase positive signal LOIP is 270 degrees.

13. The radio frequency receive circuit according to claim 10 or 11, wherein the radio frequency receive circuit further comprises a conversion circuit; and
the conversion circuit is configured to: convert a current signal output by the dual balanced frequency mixer into a first voltage signal, and output the first voltage signal.

14. The radio frequency receive circuit according to claim 13, wherein the conversion circuit comprises a first transimpedance amplification unit and a second transimpedance amplification unit;
the first transimpedance amplification unit and the second transimpedance amplification unit each comprise a second amplification unit, a first capacitor, a second resistor, a second capacitor, and a third resistor, wherein the second amplification unit comprises a fifth input end, a sixth input end, a ninth output end, and a tenth output end; and
a first end of each of the first capacitor and the second resistor is configured to be electrically connected to the fifth input end, a second end of each of the first capacitor and the second resistor is configured to be electrically connected to the ninth output end, a first end of each of the second capacitor and the third resistor is configured to be electrically connected to the sixth input end, and a second end of each of the second capacitor and the third resistor is configured to be electrically connected to the tenth output end; the fifth input end of the second amplification unit in the first transimpedance amplification unit is configured to be electrically connected to an output end of the first frequency mixing unit, the sixth input end of the second amplification unit in the first transimpedance amplification unit is configured to be electrically connected to an output end of the second frequency mixing unit, the fifth input end of the second amplification unit in the second transimpedance amplification unit is configured to be electrically connected to an output end of the third frequency mixing unit, and the sixth input end of the second amplification unit in the second transimpedance amplification unit is configured to be electrically connected to an output end of the fourth frequency mixing unit; and the ninth output end of the second amplification unit in the first transimpedance amplification unit, the tenth output end of the second amplification unit in the first transimpedance amplification unit, the ninth output end of the second amplification unit in the second transimpedance amplification unit, and the tenth output end of the second amplification unit in the second transimpedance amplification unit are all configured to output the first voltage signal.

15. The radio frequency receive circuit according to claim 14, wherein the fifth input end and the tenth output end have a same phase, and the sixth input end and the ninth output end have a same phase.

16. A receiver, comprising an antenna, a baseband processing circuit, and the radio frequency receive circuit according to any one of claims 1 to 15, wherein
the antenna is configured to send a first radio frequency signal to the radio frequency receive circuit; and
the baseband processing circuit is configured to filter and convert a first voltage signal sent by the radio frequency receive circuit, to output a second voltage signal, wherein the second voltage signal is used to indicate a voltage signal obtained through filtering and conversion.

17. An electronic device, comprising the receiver according to claim 16.
